# EUROPEAN PATENT SPECIFICATION

(11) **EP 3 138 133 B1**
(45) Date of publication and mention of the grant of the patent: **02.03.2022**
(21) Application number: 15785272.4
(22) Date of filing: 24.04.2015
(51) Int. Cl.: H01L 31/18, H01L 31/073, H01L 31/0392, H01L 31/0336

(54) **ADDITIONAL TEMPERATURE TREATMENT STEP FOR THIN-FILM SOLAR CELLS**
ZUSÄTZLICHER TEMPERATURBEHANDLUNGSSCHRITT FÜR DÜNNSCHICHT-SOLARZELLEN
ÉTAPE DE TRAITEMENT EN TEMPÉRATURE SUPPLÉMENTAIRE POUR DES CELLULES SOLAIRES À FILM MINCE

(30) Priority: 29.04.2014 DE 102014208029
(43) Date of publication of application: 08.03.2017
(73) Proprietor: China Triumph International Engineering Co., Ltd., Shanghai 200063 (CN); CTF Solar GmbH, 01099 Dresden (DE)
(72) Inventor: SHOU, Peng, Shanghai 200063 (CN); SPATH, Bettina, 01109 Dresden (DE); HARR, Michael, 01109 Dresden (DE); FRAUENSTEIN, Sven, 01109 Dresden (DE)
(74) Representative: Kailuweit & Uhlemann Patentanwälte Partnerschaft mbB
(86) International application number: PCT/CN2015/077347
(87) International publication number: WO 2015/165360

(56) References cited:
- EP-A1- 2 403 016
- WO-A1-2014/026099
- CN-A- 101 640 234
- JP-A- H11 330 506
- US-A1- 2012 042 950
- US-B2- 7 211 462
- JAE HO YUN ET AL: "Effects of post-CdCl2 treatment and pre-Cd treatment on the performance and stability of CdTe cells", PROCEEDINGS OF THE 3RD WORLD CONFERENCE ON PHOTOVOLTAIC ENERGY CONVERSION : JOINT CONFERENCE OF 13TH PV SCIENCE & ENGINEERING CONFERENCE, 30TH IEEE PV SPECIALISTS CONFERENCE, 18TH EUROPEAN PV SOLAR ENERGY CONFERENCE; OSAKA INTERNATIONAL CONGRESS CENT, 18 May 2003 (2003-05-18), pages 438-441Vol.1, XP031987601, ISBN: 978-4-9901816-0-4
- RAMESH G DHERE ET AL: "Development of substrate structure CdTe photovoltaic devices with performance exceeding 10%", PHOTOVOLTAIC SPECIALISTS CONFERENCE (PVSC), 2012 38TH IEEE, IEEE, 3 June 2012 (2012-06-03), - 8 June 2012 (2012-06-08), pages 3208-3211, XP032258477, DOI: 10.1109/PVSC.2012.6318260 ISBN: 978-1-4673-0064-3
- TIWARI A N ET AL: "CdTe solar cell in a novel configuration", PROGRESS IN PHOTOVOLTAICS: RESEARCH AND APPLICATIONS, JOHN WILEY & SONS, LTD, vol. 12, no. 1, 28 January 2004 (2004-01-28), pages 33-38, XP002434760, ISSN: 1062-7995, DOI: 10.1002/PIP.525
- Doug H Rose ET AL: "Fabrication Procedures and Process Sensitivities for CdS/CdTe Solar Cells", PROGRESS IN PHOTOVOLTAICS: RESEARCH AND APPLICATIONS, vol. 7, 1 January 1999 (1999-01-01), pages 331-340, XP055422553, DOI: 10.1002/(SICI)1099-159X(199909/10)7:5<331: :AID-PIP257>3.0.CO;2-P

## Description

### TECHNICAL FIELD

The present invention refers to an improved method for producing CdTe thin-film solar cells, respectively a semi-finished product for same, wherein the method provides for carrying out an additional temperature step after applying the CdTe layer.

### BACKGROUND

Thin-film solar cells can be produced using the superstrate method or the substrate method.

In the production of thin-film solar cells using the superstrate method according to the state of the art, on a substrate, usually of glass, a transparent front contact layer (e.g. TCO, i.e. transparent conducting oxide) is deposited. On this front contact layer, a window layer, preferably made of pure or modified CdS (cadmium sulfide) is deposited and subsequently, a layer of CdTe (cadmium telluride) is deposited on top of this. Finally the back contact layer is added.

In the state of the art, after depositing the CdTe layer, this layer needs to be activated. This is done by exposing the CdTe layer at a raised temperature (usually about 380°C to 440°C) for a set duration of time to a suitable activating agent. A preferred activating agent is for example CdCI2, which is applied as a layer, for instance by a wet-chemical process or via CVD or PVD methods, onto the CdTe layer.

Methods from prior art further provide that subsequently wet-chemical etching is performed on the cadmium telluride layer. To this end, the CdTe solar cell is exposed to an etching agent, for example it is dipped into a so-called NP etching solution. Said NP etching solution is an aqueous solution of various inorganic acids, preferably (HNO3:H3PO4:H2O). This is done in the temperature range of room temperature (18°C to about 80°C). Etching time is preferably in the range of 5 sec to 60 sec. Resulting from the etching process a Te-rich layer is formed, the thickness of which ranges from 1 nm to 300 nm.

Subsequently in methods from prior art often a Sb2Te3 layer is applied, preferably by sputtering on the Sb2Te3. Afterwards, further layers of the back contact layer sequence are applied, typically consisting of molybdenum and nickel. A corresponding method is, for example, described in US 7,211,462 B1; however in said publication there is no etching step, and merely a CdCI2 treatment of the CdS/CdTe layer stack takes place. The Sb2Te3 layer is here applied by sputtering. In other known methods for applying the Sb2Te3 layer vaporizing or electrolytic deposition are intended. If required, several Sb2Te3 layers may also be intended.

In the substrate method, the above described order of producing the solar cell is inverted. On a substrate, first the back contact layer is created, whereby the substrate itself may also serve as back contact. Then the CdTe layer is applied, and a step for activating the CdTe layer is performed by means of an activation agent. Subsequently, on the activated CdTe layer a window layer, preferably made from pure or modified CdS (cadmium sulphide), and a transparent front contact layer (e.g. TCO - transparent conducting oxide) are deposited.

After application, the CdTe layer forms a polycrystalline layer. The size distribution of the CdTe crystals depends on the manner of process control, in particular on the temperature at which the CdTe grows on the CdS layer.

Studies have shown that the polycrystalline CdTe layer has a great number of crystal defects which disadvantageously decrease the lifetime and concentration of charge carriers.

WO 2014 / 026099 A1 discloses a CdS/CdTe thin film solar cell in superstrate configuration, prepared by pulsed laser deposition (PLD) of CdS/CdTe bilayer on a FTO coated glass substrate. After deposition of CdS/CdTe, CdCI2 annealing was carried out. After CdCl2 annealing the samples were etched with Br+CH3OH before a back contact HgTe:Cu-doped graphite was painted on the cell. An additional annealing is carried out after applying the back contact to reduce the contact resistance.

EP 2403016 A1 discloses a method manufacturing a cadmium telluride based thin film photovoltaic device in superstrate configuration, wherein copper is applied to the CdTe surface after activating the CdTe layer with chloride ions. After copper is applied, an annealing is performed in order to allow diffusion of the copper ions into the CdTe layer.

Bamesh G. Dhere; 38th PHOTOVOLTAIC SPECIALISTS CONFERENCE (PVSC), 2012, 38TH IEEE; June 3-8, 2012; pp.3208-3211 (XP32258477) discloses a method for manufacturing a CdTe device in substrate structure. An additional annealing treatment is performed after the deposition of the CdS layer or after the deposition of the front contact layer.

### SUMMARY

Therefore the object is to reduce the number and extent of crystal defects in the CdTe layer.

According to the invention, the object is achieved with the methods according to claims 1 and 7. Advantageous embodiments of the method are disclosed in the corresponding dependent sub-claims.

In the following description of the method, the process steps of cleaning and sealing according to the state of the art are presumed to be known, and not explained in more detail. The deposition of anti-reflective and protective layers (such as back laminate or glass) is also presumed to be known.

Surprisingly it has been shown that the number and extension of crystal defects in the CdTe layer deposited on a substrate, which negatively impact the lifetime and concentration of charge carriers, may be reduced significantly by means of a further temperature step. Depending on the production method used, the constitution of the substrate may vary. In the superstrate method the substrate consists of a transparent substrate, the front contact layer deposited thereon, and a window layer, whereby the CdTe layer is applied on the window layer. In the substrate method, the substrate comprises a back contact layer, on which the CdTe layer is applied. The terms "front contact layer" and "back contact layer" here not only describe an individual layer, but also describe a potential layer sequence consisting of several layers applied one over the other.

Essential in this context is the requirement that this temperature step takes place after activating the CdTe layer and the subsequent step to remove the residual activation agent from the CdTe layer, wherein the temperature step is performed directly after these steps.

When performing the temperature step, the substrate is introduced in a heating chamber for a duration of preferably 5 minutes to 60 minutes, more preferably 10 minutes to 45 minutes, and particularly preferably 15 minutes to 30 minutes. In the heating chamber, the temperature is preferably set to 180°C to 380°C, more preferably from 200°C to 350°C, and particularly preferably from 220°C to 320°C. The heating chamber may contain a standard atmosphere, an inert gas atmosphere, or alternatively a vacuum. Whereas the pressure in a standard or inert gas atmosphere is 1 bar, in the vacuum it is preferably reduced to between 10-3 and 10-4 mbar.

Removal of the activation agent preferably takes place using one of two alternative process methods:
a) the layer of the activation agent is either removed without previous cooling of the substrate containing the already applied layer sequence, after layer activation, or
b) the activation agent layer is removed after cooling the substrate.

In process method a) an evaporation step at over 400°C under vacuum or alternatively sputter etching are used. Advantageously in this method cooling and subsequent heating of the substrate is avoided. A disadvantage is that the additional temperature treatment could initiate diffusion processes having negative effects on the final results.

In process method b) rinsing of the CdTe surface after cooling is intended, using a suitable solvent. The preferred solvent used is deionized water, however, using other solvents, such as alcohols, weak acids, lyes, or mixtures of different solvents, is also possible. An advantage is that this is a tried and tested process step from prior art; a disadvantage is the necessity of re-heating the substrate.

In variant a) the substrate, with the applied CdTe layer, is introduced into the heating chamber preferably directly after removing (e.g. evaporating) the residual activation agent, respectively the temperature in the heating chamber is decreased to that required for the additional temperature step. Since the substrate has already been heated in the previous process step, the substrate temperature is correspondingly reduced to that prevailing in the heating chamber. After temperature adjustment, a constant temperature is maintained.

In variant b) the substrate with the CdTe layer is introduced into the pre-heated heating chamber after removing (rinsing off) the residual activation agent. Here, too, the temperature is kept constant after the substrate has reached the temperature prevailing in the heating chamber.

If the heating chamber is executed as a vacuum chamber or filled with inert gas, the substrate is introduced into the heating chamber optionally by means of a lock according to the state of the art.

If the thin-film solar cell is produced using the superstrate method, the additional temperature step is performed directly after removing the residual activation agent.

Thus, the additional temperature step takes place before applying the back contact layer, and provided the method for producing thin-film solar cells comprises an etching step as described according to the state of the art for treating the CdTe surface, then the additional temperature step is performed before said etching step. Thereby it is avoided that the modification of the CdTe surface intended by means of the etching process is affected negatively by the temperature treatment. Furthermore, in this case preferably a lower temperature is chosen for the additional temperature step, so that a lower substrate temperature, preferably less than 350°C, prevails. This avoids a partial evaporation of the CdTe layer.

In an alternative process method, which is not part of the invention, it is intended that the additional temperature step is performed after applying the back contact layer. In this case an etching step for treating the CdTe surface may take place before the temperature step, because at that stage the CdTe surface is covered with the back contact layer, and therefore a degradation of the CdTe surface due to the effect of the temperature does not happen. Furthermore, in this case a higher temperature (preferably higher than 200°C), may be selected for the additional temperature step, which favourably affects the diffusion processes required for healing the defects in the CdTe layer.

If the thin-film solar cell is produced using the substrate method, the additional temperature step takes place prior to applying the window layer, e.g. one made of CdS. During the temperature step a lower temperature is selected, so that a substrate temperature of less than 350°C is attained to avoid a partial evaporation of the CdTe layer.

In another embodiment for the substrate method, which is not part of the invention, the additional temperature step is performed after applying the window layer and prior to applying the front contact layer, or after applying both the window layer and the front contact layer. To perform the additional temperature step after applying the window layer is particularly advantageous in the case of performing - in addition to the activation step after applying the CdTe layer - a further activation step after applying the window layer. In this case, the method according to the invention comprises the following steps:
Making available a substrate,
Applying a back contact layer onto the substrate,
Applying a CdTe layer onto the back contact layer,
Activating the CdTe layer with a suitable activation agent,
Removing the residual activation agent from the CdTe layer after activation,
Applying a window layer onto the CdTe layer,
Activating the window layer with a suitable activation agent,
Removing the residual activation agent from the window layer after activation,
Applying a front contact layer on the window layer, and
Performing a temperature treatment under vacuum or in a heating chamber filled with air or inert gas, during which treatment the substrate is exposed to a temperature ranging from 180°C to 380°C for a duration of 5 minutes to 60 minutes.

The step for temperature treatment is thereby performed after removing the activation agent from the window layer, that is, before or after applying the front contact layer. If the additional temperature step is performed after applying the front contact layer, a higher temperature, preferably over 200°C, may be selected for the additional temperature step, which has a favourable effect on the diffusion processes required for healing the defects in the CdTe layer.

By means of the additional temperature step according to the invention, the electric efficiency of the solar cell is further improved. The highest measured increase in electric efficiency was 0.9 percentage points.

### BRIEF DESCRIPTION OF THE DRAWINGS

Fig. 1 shows the heating ramp for heating a substrate under vacuum.
Fig. 2 shows the heating ramp for heating a substrate in an oven in a standard atmosphere.

### DETAILED DESCRIPTION

The substrates used in the following exemplary embodiments serve, for the major part, for research purposes. The substrates are made from float glass, having dimensions of 10 cm x 10 cm and a thickness of 3.2 mm. Onto these substrates, in the exemplary embodiments 1 and 2, the TCO layers, the CdS layers and the CdTe layers have already been deposited. If substrates are used on an industrial scale, these dimensions may significantly exceed an edge length (i.e. feed size) of 1 metre. For these substrates, the heating ramp requires adjustment to reduce the danger of breaking caused by thermal stress. The corresponding permissible heating rates are known from prior art. The most essential factor for the method according to the invention is however, that the substrate is kept for the time indicated at the temperatures indicated.

### 1. Vacuum heating chamber

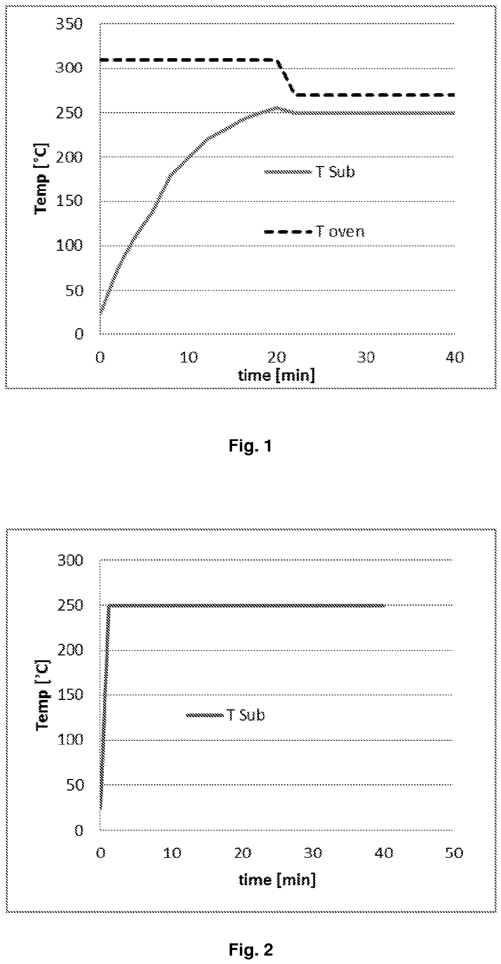

The heating ramp is shown in Fig. 1.

A substrate according to the state of the art is introduced into a vacuum heating chamber. For heating, a resistance heating according to the state of the art is used. The initial temperature of the substrate is at room temperature (20°C). The end temperature of the substrate is 250°C. The oven temperature during feed-in of samples is 310°C. The substrate is heated up at a rate of about 11.5°C/minute over a time of about 20 minutes. The substrate reaches its end temperature of 250°C. Subsequently the oven temperature is reduced to 270°C and the substrate is heated for 20 minutes at the same temperature. After the temperature step, the substrate is discharged from the heating chamber and left to cool under ambient conditions.

### 2. Heating chamber with air

Die heating ramp is shown in Fig. 2.

The substrate having ambient temperature (20°C) is introduced into the heating chamber, which has been heated up to 250°C and has a standard atmospheric pressure, and left there for a duration of 40 minutes. The temperature rise in the substrate is about 300°C/minutes.

### 3. Method for producing a solar cell using a temperature step according to the invention

Cadmium sulfide and cadmium telluride are applied using CSS deposition onto a glass substrate coated with TCO. The layer thickness is c. 70 nm for the CdS and 4 µm for the CdTe. Deposition takes place at about 500°C. Subsequently, a CdCl2-containing aqueous solution is applied, followed by a layer activation at 400°C for a duration of 25 minutes exposed to air. Afterwards, the substrate is cooled down, the excess CdCl2 is rinsed off using water, and the substrate is dried exposed to air.

Method 3a: The substrate (containing the layer sequence already present) is fed into a pre-heated vacuum chamber and the sample is annealed at 250°C for a total duration of 40 minutes (the temperature profile corresponds to that shown in Fig. 1). Subsequently the substrate is discharged and cooled down (6-9°C/minutes) to room temperature, being exposed to air.

Method 3b: The substrate (containing the layer sequence already present) is fed into an atmospheric oven pre-heated to 250°C (placing the substrate onto a hot graphite sheet) and subsequently annealed for 20 minutes. Thereafter cooling of the substrate to room temperature (6-9°C/minutes) takes place, exposed to air.

Only after this step (in method 3a or 3b), nitric-phosphoric acid etching takes place at ambient temperature (20°C) for a duration of 30 seconds (NP-etching: HNO3:H3PO4:H2O). As a result of the etching a Te-rich layer of about 150 nm thickness is formed.

Finally, the substrate is fed into a vacuum chamber and the metallic back contact is deposited.

## Claims

1. A method for producing a thin-film solar cell, comprising the steps:
a. Applying a CdTe layer onto a substrate,
b. Activating the CdTe layer using an activation agent,
c. Removing the residual activation agent from the CdTe layer after activation, and
d. Performing a temperature treatment under vacuum or in a heating chamber filled with either air, or inert gas, directly after removing the residual activation agent, during which treatment the substrate is exposed to a temperature between 180°C and 380°C for a time between 5 minutes and 60 minutes,
wherein the method further comprises the steps:
e. Providing the substrate which is a transparent substrate,
f. Applying a front contact layer onto the substrate,
g. Applying a window layer onto the front contact layer,
h. Applying a back contact layer,
wherein the steps a) to d) are performed after step g) and before step h).

2. Method according to claim 1, **characterized in that** in step c) the residual activation agent is evaporated off, and afterwards the additional temperature treatment takes place without any interim cooling.

3. Method according to claim 1, **characterized in that**, after activation of the CdTe layer, the substrate containing the layer sequence already present is cooled down to room temperature, and the residual activation agent is rinsed off with a suitable solvent in step c), after which the additional temperature treatment takes place, wherein the solvent is either deionized water, an alcohol, a weak acid, a lye, or a mixture of different solvents .

4. Method according to any of the previous claims, **characterized in that** the activation agent is CdCl₂.

5. Method according to any of the previous claims, **characterized in that**, the resulting temperature of the substrate during step d) is less than 350°C.

6. Method according to claim 5, **characterized in that** the method further comprises an etching step for the surface treatment of the CdTe layer, wherein said etching step takes place after step d).

7. A method for producing a thin-film solar cell, comprising the steps:
a. Applying a CdTe layer onto a substrate,
b. Activating the CdTe layer using an activation agent,
c. Removing the residual activation agent from the CdTe layer after activation, and
d. Performing a temperature treatment under vacuum or in a heating chamber filled with either air, or inert gas, after removing the residual activation agent, during which treatment the substrate is exposed to a temperature between 180°C and 380°C for a time between 5 minutes and 60 minutes,
wherein the method further comprises the steps:
i. Providing the substrate,
j. Applying a back contact layer onto the substrate,
k. Applying a window layer,
I. Applying a front contact layer onto the window layer,
wherein the steps a) to d) are performed between step j) and step k), and step d) is performed directly after step c).

8. Method according to claim 7, **characterized in that** the resulting temperature of the substrate during step d) is less than 350°C.

9. Method according to any of the previous claims, **characterized in that** the window layer consists of pure or modified CdS.

## Patentansprüche

1. Verfahren zur Herstellung einer Dünnschicht-Solarzelle, mit den Schritten:
a. Aufbringen einer CdTe-Schicht auf ein Substrat,
b. Aktivieren der CdTe-Schicht mit einem Aktivierungsagens,
c. Entfernen des verbliebenen Aktivierungsagens von der CdTe-Schicht nach dem Aktivieren und
d. Ausführen einer Temperaturbehandlung im Vakuum oder in einer luft- oder inertgasgefüllten Heizkammer unmittelbar nach dem Entfernen des verbliebenen Aktivierungsagens, bei der das Substrat für einen Zeitraum zwischen 5 min und 60 min einer Temperatur zwischen 180°C und 380°C ausgesetzt wird,
wobei das Verfahren weiterhin die Schritte umfasst:
e. Bereitstellen des Substrates, welches ein transparentes Substrat ist,
f. Aufbringen einer Frontkontaktschicht auf das Substrat,
g. Aufbringen einer Fenster-Schicht auf die Frontkontaktschicht,
h. Aufbringen einer Rückkontaktschicht,
wobei die Schritte a) bis d) nach dem Schritt g) und vor dem Schritt h) ausgeführt werden.

2. Verfahren nach Anspruch 1, **dadurch gekennzeichnet, dass** in Schritt c) das verbliebene Aktivierungsagens abgedampft wird und anschließend ohne zwischenzeitliche Abkühlung die zusätzliche Temperaturbehandlung erfolgt.

3. Verfahren nach Anspruch 1, **dadurch gekennzeichnet, dass** nach dem Aktivieren der CdTe-Schicht das Substrat mit der bereits vorhandenen Schichtfolge auf Umgebungstemperatur abgekühlt wird und das verbliebene Aktivierungsagens in Schritt c) mit einem geeigneten Lösungsmittel abgewaschen wird und danach die zusätzliche Temperaturbehandlung erfolgt, wobei das Lösungsmittel deionisiertes Wasser, ein Alkohol, eine schwache Säure, eine Lauge oder eine Mischung verschiedener Stoffe ist.

4. Verfahren nach einem der vorhergehenden Ansprüche, **dadurch gekennzeichnet, dass** das Aktivierungsagens CdCl2 ist.

5. Verfahren nach einem der vorhergehenden Ansprüche, **dadurch gekennzeichnet, dass** die sich ergebende Temperatur des Substrates während des Schrittes d) kleiner 350°C ist.

6. Verfahren nach Anspruch 5, **dadurch gekennzeichnet, dass** das Verfahren weiterhin einen Ätzschritt zur Behandlung der Oberfläche der CdTe-Schicht umfasst, wobei dieser Ätzschritt nach dem Schritt d) erfolgt.

7. Verfahren zur Herstellung einer Dünnschicht-Solarzelle, mit den Schritten:
a. Aufbringen einer CdTe-Schicht auf ein Substrat,
b. Aktivieren der CdTe-Schicht mit einem Aktivierungsagens,
c. Entfernen des verbliebenen Aktivierungsagens von der CdTe-Schicht nach dem Aktivieren und
d. Ausführen einer Temperaturbehandlung im Vakuum oder in einer luft- oder inertgasgefüllten Heizkammer nach dem Entfernen des verbliebenen Aktivierungsagens, bei der das Substrat für einen Zeitraum zwischen 5 min und 60 min einer Temperatur zwischen 180°C und 380°C ausgesetzt wird,
wobei das Verfahren weiterhin die Schritte umfasst:
i. Bereitstellen des Substrats,
j. Aufbringen einer Rückkontaktschicht auf das Substrat,
k. Aufbringen einer Fenster-Schicht,
I. Aufbringen einer Frontkontaktschicht auf die Fensterschicht,
wobei die Schritte a) bis d) zwischen dem Schritt j) und dem Schritt k) erfolgen und der Schritt d) unmittelbar nach dem Schritt c) erfolgt.

8. Verfahren nach Anspruch 7, **dadurch gekennzeichnet, dass** die sich ergebende Temperatur des Substrates während des Schrittes d) kleiner 350°C ist.

9. Verfahren nach einem der vorhergehenden Ansprüche, **dadurch gekennzeichnet, dass** die Fensterschicht aus reinem oder modifiziertem CdS besteht.

## Revendications

1. Procédé de production d'une cellule solaire à film mince, comprenant les étapes suivantes :
a. l'application d'un film CdTe sur un substrat,
b. l'activation du film CdTe à l'aide d'un agent d'activation,
c. l'élimination de l'agent d'activation résiduel du film CdTe après l'activation, et
d. la réalisation d'un traitement en température sous vide ou dans une chambre de chauffage remplie soit d'air, soit de gaz inerte, directement après l'élimination de l'agent d'activation résiduel, pendant lequel traitement le substrat est exposé à une température comprise entre 180 °C et 380 °C pendant une durée comprise entre 5 minutes et 60 minutes,
dans lequel le procédé comprend en outre les étapes suivantes :
e. la fourniture du substrat qui est un substrat transparent,
f. l'application d'un film de contact avant sur le substrat,
g. l'application d'un film fenêtre sur le film de contact avant,
h. l'application d'un film de contact arrière,
dans lequel les étapes a) à d) sont effectuées après l'étape g) et avant l'étape h).

2. Procédé selon la revendication 1, **caractérisé en ce que**, à l'étape c), l'agent d'activation résiduel est évaporé, puis le traitement en température supplémentaire a lieu sans refroidissement intermédiaire.

3. Procédé selon la revendication 1, **caractérisé en ce que**, après l'activation du film CdTe, le substrat contenant la séquence de films déjà présente est refroidi à température ambiante et l'agent d'activation résiduel est rincé avec un solvant approprié à l'étape c), après quoi le traitement en température supplémentaire a lieu, le solvant étant soit de l'eau désionisée, soit un alcool, soit un acide faible, soit une lessive ou soit un mélange de différents solvants.

4. Procédé selon l'une quelconque des revendications précédentes, **caractérisé en ce que** l'agent d'activation est le CdCl₂.

5. Procédé selon l'une quelconque des revendications précédentes, **caractérisé en ce que** la température résultante du substrat lors de l'étape d) est inférieure à 350 °C.

6. Procédé selon la revendication 5, **caractérisé en ce que** le procédé comprend en outre une étape de gravure pour le traitement de surface du film CdTe, ladite étape de gravure ayant lieu après l'étape d).

7. Procédé de production d'une cellule solaire à film mince, comprenant les étapes suivantes :
a. l'application d'un film CdTe sur un substrat,
b. l'activation du film CdTe à l'aide d'un agent d'activation,
c. l'élimination de l'agent d'activation résiduel du film CdTe après l'activation, et
d. la réalisation d'un traitement en température sous vide ou dans une chambre de chauffage remplie soit d'air, soit de gaz inerte, après l'élimination de l'agent d'activation résiduel, pendant lequel traitement le substrat est exposé à une température comprise entre 180 °C et 380 °C pendant une durée comprise entre 5 minutes et 60 minutes,
dans lequel le procédé comprend en outre les étapes suivantes :
i. la fourniture du substrat,
j. l'application d'un film de contact arrière sur le substrat,
k. l'application d'un film fenêtre,
I. l'application d'un film de contact avant sur le film fenêtre,
dans lequel les étapes a) à d) sont effectuées entre l'étape j) et l'étape k), et l'étape d) est effectuée directement après l'étape c).

8. Procédé selon la revendication 7, **caractérisé en ce que** la température résultante du substrat lors de l'étape d) est inférieure à 350 °C.

9. Procédé selon l'une quelconque des revendications précédentes, **caractérisé en ce que** le film fenêtre est constitué de CdS pur ou modifié.
